# EUROPÄISCHE PATENTSCHRIFT

(11) **EP 0 556 581 B1**
(45) Veröffentlichungstag und Bekanntmachung des Hinweises auf die Patenterteilung: **09.04.1997**
(21) Anmeldenummer: 93100838.7
(22) Anmeldetag: 21.01.1993
(51) Int. Cl.: H01L 39/24

(54) **Verfahren zur Herstellung eines oxidkeramischen Supraleiters mit hoher Kerndichte**
Method of making ceramic oxide superconductors of high core density
Méthode pour la fabrication de supraconducteurs en oxyde céramique à densité de noyau élevée

(30) Priorität: 19.02.1992 DE 4205008
(43) Veröffentlichungstag der Anmeldung: 25.08.1993
(73) Patentinhaber: Vacuumschmelze GmbH, 63450 Hanau (DE)
(72) Erfinder: Tenbrink, Johannes, Dr., W-8752 Mömbris (DE); Puniska, Paul, W-6451 Neuberg 1 (DE); Glücklich, Volker, W-6451 Hammersbach (DE); Heine, Klaus, Dr., W-6053 Obertshausen (DE)
(74) Vertreter: Fuchs, Franz-Josef, Dr.-Ing.

(56) Entgegenhaltungen:
- AMERICAN CERAMIC SOCIETY BULLETIN Bd. 70, Nr. 5, Mai 1991, NEW YORK, US Seiten 813 - 816 Balachandran U. et al 'Hot Extrusion of High-Temperature Superconducting Oxides'
- MATERIALS LETTERS Bd. 10, Nr. 11, M rz 1991, AMSTERDAM, NL Seiten 485 - 488 Matsuzaki K. et al 'Production of a superconducting Bi-Pb-Sr-Ca-Cu oxide wire using a hot-extrusion process'
- SUPERCONDUCTOR SCIENCE AND TECHNOLOGY Bd. 4, Nr. 7, Juli 1991, LONDON, UK Seiten 353 - 354 Whitlow G.A. et al 'High current density Bi-Sr-Ca-Cu-O superconductor wires produced by hot isostatic pressing'
- PATENT ABSTRACTS OF JAPAN vol. 13, no. 196 (E-755)10. Oktober 1989 & JP-A-1019625

## Beschreibung

Die Erfindung betrifft ein Verfahren zur Herstellung eines supraleitenden Verbundkörpers durch Einbringen eines oxidkeramischen supraleitenden Materials in eine Hülle, querschnittsreduzierendes Verformen und Wärmebehandeln zur Erholung und Einstellung der Sauerstoffkonzentration sowie einen entsprechenden supraleitenden Verbundkörper.

Supraleitende Verbundkörper, bei denen ein oxidkeramisches supraleitendes Pulver von einem Hüllmaterial umschlossen ist, sind beispielsweise aus der Veröffentlichung von H. Krauth und A. Szulczyk in METALL, Jg. 45, 1989, Seiten 418 ff bekannt. Durch die Verwendung oxidkeramischer Hochtemperatursupraleiter (HTSL) werden Verbundkörper wie Drähte oder Bänder hergestellt, die auch oberhalb der Temperatur des flüssigen Stickstoffs supraleitend sind. Die hierfür geeigneten Materialien sind an sich bekannt. Hierzu gehören beispielsweise Phasen in den Systemen YBaCuO, BiSrCaCuO und TlBaCaCuO.

Zur Herstellung technischer Leiter wird oxidkeramisches Pulver beispielsweise in ein Metallrohr eingefüllt, und durch querschnittsreduzierende Verformung wird ein Draht oder ein Band hergestellt. Abschließend wird eine Wärmebehandlung durchgeführt, die der Erzeugung der durchgehend supraleitenden Verbindung durch das HTSL-Material und der Optimierung der kritischen Stromdichte dient.

Die Hülle besteht in der Regel aus Silber oder Silberlegierungen, da durch diese Materialien die Sauerstoffpermeation durch das Hüllmaterial während der abschließenden Wärmebehandlung zur Einstellung des optimalen Sauerstoffgehaltes gewährleistet ist.

In SUPERCONDUCTOR SCIENCE and TECHNOLOGY, Bd. 4, Nr. 7, 1991, Seiten 353 bis 354, ist ein derartiger Verbundsupraleiter beschrieben, der durch Kaltverformungschritte auf den vorgesehenen Querschnitt gebracht wird. Im Anschluß daran findet eine Wärmebehandlung unter hydrostatischem Druck in einer Argonatmosphäre statt.

Um bei der Herstellung der Verbundkörper eine gegenüber diesem Bekannten höhere Fülldichte zu erreichen, kann in die Hüllrohre neben Pulvern auch zu Stangen oder Pellets gepreßtes Pulver oder eine Schmelze gefüllt werden. Bei Verwendung von Pulvern wird eine Fülldichte von ca. 55 %, bezogen auf die theoretische HTSL-Dichte erreicht. Bei Verwendung der zu Stangen oder Pellets gepreßten Pulver werden Fülldichten von etwa 70 % und bei Einfüllen einer Schmelze eine Fülldichte von bis zu 100 % erreicht. Nach der Verformung der gefüllten Rohre zu fertigen Verbunddrähten durch Ziehen oder eine Kombination von Zieh- und Walzschritten beträgt die Kerndichte des oxidkeramischen Supraleitermaterials typischerweise 65 bis 75 % der theoretischen Dichte. Bei der abschließenden Glühung zur Einstellung der supraleitenden Eigenschaften kommt es dann aufgrund des damit verbundenen teilweisen Schmelzens des Kerns zur Bildung großer Poren im HTSL-Kern, die eine stark verringerte kritische Stromdichte zur Folge haben. Diese Poren sind somit unerwünscht und sollen weitgehend vermieden werden.

Weiterhin ist es aus AMERICAN CERAMIC SOCIETY BULLETIN, Bd. 70, Nr. 5, 1991, S. 813 - 816 bekannt, einen Preßkörper zu verwenden, der unter erhöhter Temperatur durch Strangpressen verformt wird. Beim Strangpressen darf jedoch das Innere des zu pressenden Bolzens nicht flüssig sein, um eine kontrollierte Verformung des Materials zu gewährleisten. Daher ist ausgeführt, daß der Bolzen auf 70 bis 90 % der Schmelztemperatur aufgeheizt wird. Durch Strangpressen hergestelltes Supraleitermaterial ist außerdem in MATERIALS LETTERS, Bd. 10, Nr. 11, 1991, S. 485 - 488 beschrieben. Hier ist als Strangpreßtempertur ein Wert von 1113 K = 840 °C angegeben. Da das Supraleitermaterial in Luft erst ab 890°C teilweise zu schmelzen beginnt, ist auch hier vermieden worden, daß ein Aufschmelzen des Supraleitermaterials bei der Heißverformung auftritt.

Aufgabe der Erfindung ist es daher, bei einem Supraleiterdraht, bei dem sich das Supraleitermaterial in einer Hülle befindet, ein Verfahren zur Herstellung von oxidkeramischen Verbundkörpern anzugeben, bei denen sich eine erhöhte Kerndichte für den Verbundkörper erreichen läßt und gleichzeitig die Bildung von großen Poren im HTSL-Kern vermieden wird.

Diese Aufgabe wird in einem Verfahren zur Herstellung eines surpraleitenden Verbundkörpers dadurch gelöst, daß das querschnittsreduzierende Verformen mindestens einen Heißverformungsschritt enthält, bei dem das Supraleitermaterial im geschmolzenen oder partiell geschmolzenen Zustand vorliegt. Ein erfindungsgemäßer supraleitender Verbundkörper weist eine Kerndichte von mehr als 80 % der theoretischen Dichte auf.

Mit dem erfindungsgemäßen Verfahren wird somit eine Erhöhung der Kerndichte dadurch erreicht, daß ein Heißverformungsschritt vorgesehen ist, bei dem das Supraleitermaterial im geschmolzenen oder partiell geschmolzenen Zustand vorliegt und somit plastisch verformbar ist. Bei diesem Heißverformungsschritt kann es sich insbesondere um ein Heißziehen oder Heißwalzen handeln. Aus der nicht vorveröffentlichten deutschen Patentanmeldung P 41 04 421.5 ist zwar bereits ein Verfahren zur Herstellung eines supraleitenden Verbundkörpers bekannt, bei dem ein Heißwalzen durchgeführt wird; jedoch liegt dort die Temperatur beim Heißwalzen noch unterhalb der Schmelztemperatur des supraleitenden Materials, so daß noch kein partielles Schmelzen desselben auftritt. Speziell angegeben ist dort ein BiSrCaCuO-Supraleitermaterial mit einer Schmelztemperatur von 890 °C. Bei diesem Supraleitermaterial soll die Temperatur beim Heißwalzen zwischen 500 und 800 °C betragen und liegt somit noch deutlich unterhalb der Schmelztemperatur.

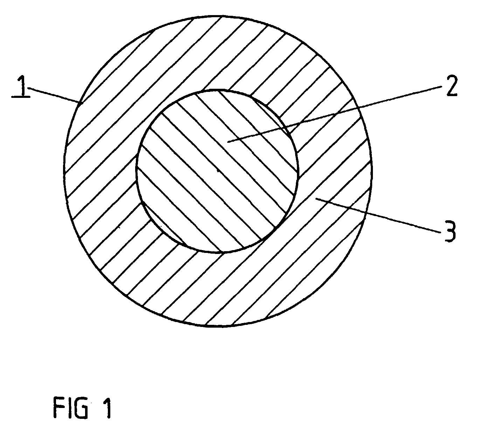

Fig. 1 zeigt einen erfindungsgemäßen supraleitenden Verbundkörper 1 mit einem Kern 2 aus oxidkeramischem Supraleitermaterial und einer Hülle 3, die vorzugsweise aus Silber oder einer Silberlegierung besteht.

In einem speziellen Ausführungsbeispiel wurde ein Einkernleiter mit einem Kern aus einer BiSrCaCuO-Supraleiterverbindung (2212-Phase) und einer Silberhülle hergestellt. Die querschnittsreduzierende Verformung erfolgte dabei durch Ziehen. Der Verbundkörper wurde vor dem Ziehen zur Schmierung mit einer Graphitsuspension beschichtet und auf eine Temperatur oberhalb der Schmelztemperatur des oxidkeramischen Materials vorgewärmt. Die Temperatur der letzten Erwärmungsstufe betrug hierbei etwa 930 °C. Der Ziehstein wurde ebenfalls aufgeheizt, und zwar auf eine Temperatur von über 500 °C. Mit einer Ziehgeschwindigkeit von 3 bis 4 m pro Minute wurde der Verbundkörper von einem Durchmesser von 1,46 mm durch Heißziehen in einem Zug auf einen Durchmesser von 1,39 mm gebracht. Die Kerndichte stieg dabei von 68 % der theoretischen Dichte auf 83 % nach dem Heißziehen. Ein zweiter Zug auf einen Durchmesser von 1,31 mm brachte eine weitere geringfügige Erhöhung der Kerndichte auf 84 %.

Analog zu dem beschriebenen Heißziehen kann die querschnittsreduzierende Verformung auch durch erfindungsgemäßes Heißwalzen mit angewärmten Walzen durchgeführt werden. Die bevorzugte Temperatur der Walzen, wie auch des Ziehsteins beim Ziehen, liegt dabei zwischen 400 und 700 °C.

In Vergleichsversuchen wurden zur Querschnittsreduzierung verschiedene Verfahren durchgeführt und deren Eignung zur Erhöhung der Kerndichte untersucht. Es handelt es sich dabei um das Walzen nach Vorwärmen, jedoch bei Temperaturen unterhalb der Schmelztemperatur des oxidkeramischen Materials, uniaxiales Pressen sowie uniaxiales Heißpressen bei 630 °C und heißisostatisches Pressen bei 750 °C. In keinem Fall wurde eine Erhöhung der Kerndichte mit diesen Vergleichsversuchen erzielt.

Während in dem Ausführungsbeispiel die Herstellung eines Einkernleiters beschrieben wurde, können mit dem erfindungsgemäßen Verfahren auch an sich bekannte Mehrkernleiter hergestellt werden.

## Patentansprüche

1. Verfahren zur Herstellung eines supraleitenden Verbundkörpers (1) durch
- Einbringen eines oxidkeramischen Supraleitermaterials in eine rohrförmige Hülle (3),
- ein mindestens zweistufiges querschnittsreduzierendes Verformen, wobei bei mindestens einer Verformungsstufe ein Magnetfeld angelegt wird, und
- Wärmebehandeln zur Erholung und Einstellung der Sauerstoffkonzentration,
**dadurch gekennzeichnet**, daß das querschnittsreduzierende Verformen mindestens einen durch Walzen oder Ziehen erfolgenden Heißverformungsschritt bei einer solchen Temperatur enthält, bei der das Supraleitermaterial im geschmolzenen oder partiell geschmolzenen Zustand vorliegt.

2. Verfahren nach Anspruch 1, **dadurch gekennzeichnet**, daß der Ziehstein oder die Walzen angewärmt sind, vorzugsweise auf 400 bis 700°C.

3. Verfahren nach einem der vorhergehenden Ansprüche, **dadurch gekennzeichnet**, daß es sich um einen Mehrkernleiter handelt.

4. Supraleitender Verbundkörper (1) nach Anspruch 1, **dadurch gekennzeichnet**, daß der supraleitende Kern eine Dichte von mehr als 80 % der theoretischen Dichte aufweist.

## Claims

1. Method of producing a superconducting composite body (1) by
- introducing an oxide ceramic superconductor material into a tubular envelope (3),
- shaping this intermediate body by cross-section-reducing shaping in at least two stages, with a magnetic field being applied during at least one shaping stage, and
- heat treating the composite for recovery and setting the oxygen concentration,
characterized in that the cross-section-reducing shaping comprises at least one hot-shaping step by rolling or drawing at a temperature at which the superconductor material is present in a molten or partially molten state.

2. Method according to Claim 1, characterized in that the drawing die or the rollers are heated, preferably to from 400 to 700°C.

3. Method according to any of the preceding claims, characterized in that the composite body is a multicore conductor.

4. Superconducting composite body (1) according to Claim 1, characterized in that the superconducting core has a density of more than 80% of the theoretical density.

## Revendications

1. Procédé de fabrication d'un corps composite (1) supraconducteur par
- introduction d'une matière supraconductrice d'oxyde céramique dans une enveloppe tubulaire (3),
- façonnage réduisant la section transversale en au moins deux étapes, un champ magnétique étant appliqué dans au moins une étape de façonnage, et
- traitement à chaud pour le rétablissement et le réglage de la concentration en oxygène,
caractérisé en ce que le façonnage réduisant la section transversale contient au moins une étape de façonnage à chaud s'effectuant par laminage ou étirage à une température à laquelle la matière supraconductrice est présente à l'état fondu ou partiellement fondu.

2. Procédé selon la revendication 1, caractérisé en ce que la filière ou les cylindres sont préchauffés, de préférence à 400 à 700 °C.

3. Procédé selon l'une des revendications précédentes, caractérisé en ce qu'il s'agit d'un conducteur à plusieurs noyaux.

4. Corps composite (1) supraconducteur selon la revendication 1, caractérisé en ce que le noyau supraconducteur présente une densité de plus de 80 % de la densité théorique.
